# EUROPEAN PATENT SPECIFICATION

(11) **EP 4 411 793 B1**
(45) Date of publication and mention of the grant of the patent: **09.09.2026**
(21) Application number: 22875188.9
(22) Date of filing: 30.09.2022
(51) Int. Cl.: B61B 3/02, H10P 72/30

(54) **LATERAL TRANSFER DEVICE, AIR TRANSPORT APPARATUS, AND AUTOMATIC MATERIAL HANDLING SYSTEM**
SEITLICHE TRANSFERVORRICHTUNG, LUFTTRANSPORTVORRICHTUNG UND AUTOMATISCHES MATERIALHANDHABUNGSSYSTEM
DISPOSITIF DE TRANSFERT LATÉRAL, APPAREIL DE TRANSPORT D'AIR ET SYSTÈME DE MANIPULATION DE MATÉRIAU AUTOMATIQUE

(30) Priority: 30.09.2021 CN 202111166879; 30.09.2021 CN 202122405944 U; 30.09.2021 CN 202111166799
(43) Date of publication of application: 07.08.2024
(73) Proprietor: Meetfuture Technology (Shanghai) Co., Ltd., Shanghai 200131 (CN)
(72) Inventor: DU, Baobao, Shanghai 200131 (CN); MIAO, Feng, Shanghai 200131 (CN)
(74) Representative: Balder IP Law, S.L.
(86) International application number: PCT/CN2022/123434
(87) International publication number: WO 2023/051808

(56) References cited:
- CN-A- 107 857 064
- CN-A- 111 071 713
- CN-A- 112 185 866
- CN-A- 112 777 194
- CN-A- 113 871 335
- JP-A- 2016 196 359
- JP-B2- 5 169 065
- JP-B2- 6 677 187
- KR-A- 20210 010 040
- KR-B1- 102 168 479
- US-A1- 2007 224 026
- US-B2- 10 340 167

## Description

### TECHNICAL FIELD

Embodiments of the present application relate to the technical field of automatic control, more specifically to a semiconductor manufacturing equipment, and in particular to a transversing loading device, an overhead hoist vehicle including the same, and an automatic material handling system.

### BACKGROUND

In recent years, the semiconductor industry has flourished, and the rapid development of semiconductor chip production technology has also put forward higher requirements for a semiconductor wafer foundry (i.e., a wafer factory, a Fab factory, etc.).

At present, the wafer factory adopts an automatic material handling system (AMHS) on a large scale to quickly and accurately transport carriers containing wafer materials to their destinations based on the AMHS, to reduce idle time of wafers, reduce misoperations, thereby improving production efficiency.

For example, US 2027/224026 A1 describes a transferring system to stably support a hoist unit. US 10340167 B2 describes a robot moving along a moving rail and transferring an article. JP6677187 B2 discloses an article transportation facility including a travelling rail installed along a travelling route and an article transportation vehicle travelling on the travelling rail.

### SUMMARY

The invention is set out in the appended set of claims.

The present application provides a transversing loading device, an overhead hoist vehicle, and automatic material handling system that can bring at least one of the following beneficial effects.

By using the transversing loading device provided according to the present application, the picking-up and fixing mechanism is stably and reliably connected to the bottom surface of a travelling base plate of the overhead hoist vehicle. With the horizontal adjusting mechanism, the lifting mechanism and the clamping mechanism in the overhead hoist vehicle can be quickly and accurately adjusted to above the target object to be handled by a horizontal adjusting mechanism, which can improve the production efficiency of the product and better meet the needs of the factory.

### BRIEF DESCRIPTION OF THE DRAWINGS

For more clearly illustrating embodiments of the present application or the technical solutions in the conventional technology, drawings referred to for describing the embodiments or the conventional technology will be briefly described hereinafter. Apparently, drawings in the following description are only examples of the present application, and for the person skilled in the art, other drawings may be acquired based on the provided drawings without any creative efforts.
FIG. 1 is an axonometric view of a transversing loading device provided according to some embodiments of the present application;
FIG. 2 is a top view of a transversing loading device provided according to some embodiments of the present application;
FIG. 3 is another top view of a transversing loading device provided according to some embodiments of the present application;
FIG. 4 is a cross-sectional view of a transversing loading device provided according to some embodiments of the present application;
FIG. 5 is a schematic structural view of a rotating mechanism in a transversing loading device provided according to some embodiments useful for understanding the present invention;
FIG. 6 is a cross-sectional view of an overhead hoist vehicle provided according to some embodiments of the present application;
FIG. 7 is a schematic structural view of a vehicle body in an overhead hoist vehicle provided according to some embodiments of the present application;
FIG. 8 is a schematic structural view of a transversing loading device connected to a lifting mechanism by a rotating shaft in an overhead hoist vehicle provided according to some embodiments of the present application;
FIG. 9 is a schematic structural view of a travelling mechanism in an overhead hoist vehicle provided according to some embodiments of the present application;
FIG. 10 is a schematic structural view of a travelling mechanism in an overhead hoist vehicle provided according to some embodiments of the present application during travelling;
FIG. 11 is a schematic structural view of a travelling device provided according to some embodiments of the present application;
FIG. 12 is a schematic structural view of a travelling mechanism in an overhead hoist vehicle provided according to some embodiments of the present application during travelling;
FIG. 13 is a schematic structural view of a travelling device provided according to some embodiments of the present application;
FIG. 14 is a side view of a wireless power receiving device of a travelling mechanism in an overhead hoist vehicle provided according to some embodiments of the present application;
FIG. 15 is a cross-sectional view of a wireless power receiving device of a travelling mechanism in an overhead hoist vehicle provided according to some embodiments of the present application;
FIG. 16 is a schematic structural view of a travelling device provided according to some embodiments of the present application;
FIG. 17 is a schematic structural view of a clamping mechanism in an overhead hoist vehicle provided according to some embodiments of the present application
FIG. 18 is a front view of a clamping mechanism in an overhead hoist vehicle provided according to some embodiments of the present application;
FIG. 19 is a schematic structural view of a clamping mechanism in another overhead hoist vehicle provided according to some embodiments of the present application;
FIG. 20 is a schematic structural view of an anti-drop mechanism in overhead hoist vehicle provided by some embodiments of the present application in response to the anti-drop mechanism extending;
FIG. 21 is a schematic structural view of an anti-drop mechanism in overhead hoist vehicle provided by some embodiments of the present application in response to the anti-drop mechanism retracting; and
FIG. 22 is a schematic structural view of an automatic material handling system provided according to some embodiments of the present application.

### DETAILED DESCRIPTION

The object of the present application embodiment is to provide a transversing loading device, an overhead hoist vehicle, and an automatic material handling system, which can improve the production efficiency of the product and better meet the needs of the factory. According to the present invention, the problem is solved by the subject-matter outlined in the independent claims.

A transversing loading device applied to an overhead hoist vehicle is provided according to some embodiments of the present application, and the transversing loading device includes a picking-up and fixing mechanism fixedly connected to the travelling base plate of the overhead hoist vehicle, a horizontal adjusting mechanism installed on a lower surface of the picking-up and fixing mechanism. The horizontal adjusting mechanism includes a synchronous adjusting mechanism and a sliding mechanism. The synchronous adjusting mechanism is arranged on a side surface of the sliding mechanism, and is configured to adjust the sliding mechanism to a predetermined horizontal position relative to the travelling base plate along the first direction. The first direction is a horizontal direction perpendicular to the side surface, and the predetermined horizontal position is a position above a target object to be handled. In the transversing loading device, the overhead hoist vehicle, and the automatic material handling system provided according to the present application, the picking-up and fixing mechanism is stably and reliably connected to the lower surface of the travelling base plate of the overhead hoist vehicle through a new transversing loading device. With the horizontal adjusting mechanism, the lifting mechanism and the clamping mechanism in the overhead hoist vehicle can be quickly and accurately adjusted to above the target object to be handled by a horizontal adjusting mechanism, which can improve the production efficiency of the product and better meet the needs of the factory.

In order to clarify the purpose, technical solution, and advantages of some embodiments of the present application, the following will provide a detailed explanation of some embodiments of the present application in conjunction with the accompanying drawings.

The embodiments of the present application provide a transversing loading device (i.e., a transversing loading mechanism, which will not be distinguished below), which is applied to overhead hoist vehicle. The grasping device (e.g., a lifting mechanism, a clamping mechanism, a vehicle body, etc.) can be quickly and accurately adjusted in the horizontal direction to a space above the target object to be handled (e.g., a wafer box), which facilitates fast and accurate grasping of the target object and improving production efficiency.

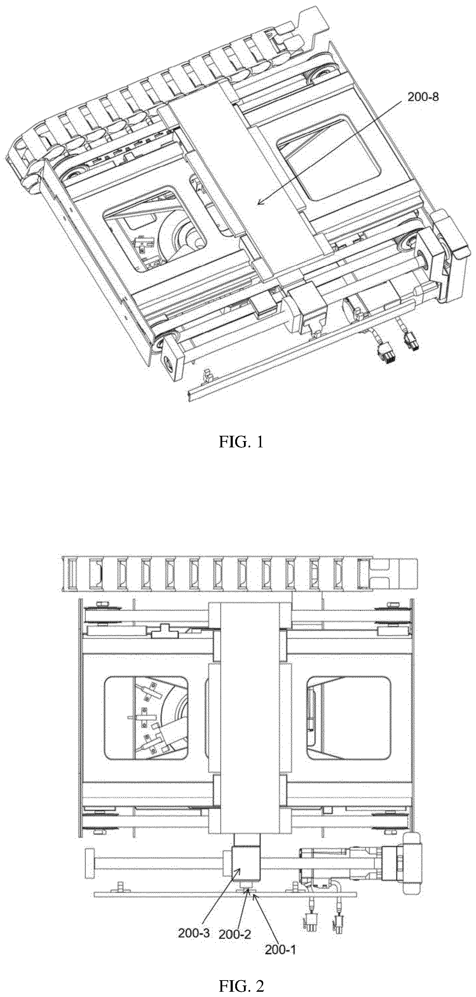

As shown in FIG. 1 to FIG. 5, the transversing loading device includes a picking-up and fixing mechanism 200-8 and a horizontal adjusting mechanism.

According to the claimed invention, the picking-up and fixing mechanism 200-8 is fixedly connected to the travelling base plate of the overhead hoist vehicle. For example, the picking-up and fixing mechanism 200-8 is embodied as a fork fixing plate, and the fork fixing plate may be a sliding rail type pallet fork structure, that is, an upper part of the fork fixing plate is a sliding rail connection seat, and a lower part of the fork fixing plate is a sliding rail structure. In this case, the upper part of the cargo fixing mechanism 200-8 (e.g., the sliding rail connection seat) can be fixed and installed on the lower surface of the travelling base plate of the overhead hoist vehicle (not shown in the figure), and the lower part of the picking-up and fixing mechanism 200-8 (e.g., the slide rail structure) is installed on a horizontal adjusting mechanism. It is not only can firmly fix the overall transversing loading device under the travelling base plate by the slide rail connection seat, but also the horizontal adjusting mechanism can move to a designated position according to the adjustment needs through the slide rail structure.

The horizontal adjusting mechanism is installed on the lower surface of the picking-up and fixing mechanism 200-8, where the horizontal adjusting mechanism includes a synchronous adjusting mechanism and a sliding mechanism. The synchronous adjusting mechanism is arranged on two sides of the sliding mechanism (as shown in the upper left side and lower right side in FIG. 1), respectively, and is configured to move the sliding mechanism along the first direction relative to the travelling base plate to a predetermined horizontal position. The first direction is a horizontal direction perpendicular to the side surface, and the predetermined horizontal position is a position above a target object to be handled.

In some embodiments, the synchronous adjusting mechanism can move relative to the travelling base plate along the first direction to drive the sliding mechanism to slide to a predetermined horizontal position along the first direction. For example, the above picking-up and fixing mechanism 200-8 is a fork mechanism in a slide rail type. In this case, the upper part of the picking-up and fixing mechanism 200-8 is a slide rail connection seat connected to the lower surface of the travelling base plate, while the lower part of the picking-up and fixing mechanism 200-8 is a sliding slide rail structure. The sliding mechanism can be installed at the lower part of the picking-up and fixing mechanism 200-8 to make the overall horizontal adjusting mechanism slide relative to the travelling base plate in the horizontal plane under the adjustment of the synchronous adjusting mechanism.

In some embodiments, other components of the overhead hoist vehicle can be lifted below the sliding mechanism, such as directly lifting the grasping portion (e.g., a clamping mechanism), a lifting mechanism for lifting the grasping portion, a vehicle body, etc., which is not limited hereto.

In some embodiments, the first direction is defined as to the same as the travelling direction of the overhead hoist vehicle, so that the adjustment along the first direction can be quickly performed, the sliding mechanism can be quickly adjusted to the space above the target object to be handled.

For example, in the Fab factory, the wafer box is placed on the ground below the travelling track, and overhead hoist vehicle will pass over the wafer box while traveling along the travelling track. In response to the wafer box being handled by the overhead hoist vehicle, it will follow the preset route and stop on the travelling track above the wafer box. In actual production, the wafer box may not be accurately placed on a predetermined position on the ground, and in this case, the overhead hoist vehicle may be located directly above the wafer box, or slightly deviated from the position directly above the wafer box.

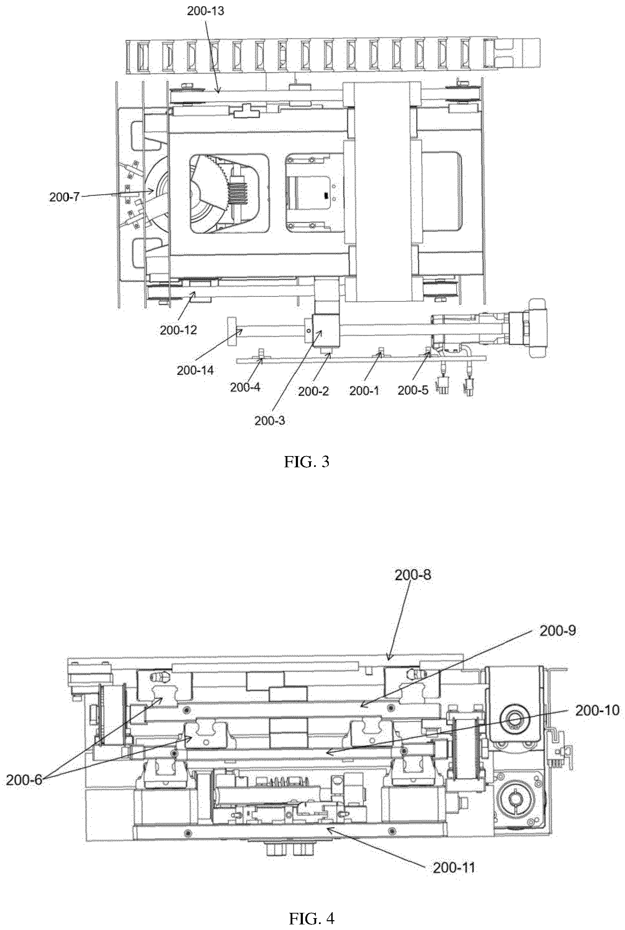

In this case, in response to the overhead hoist vehicle being located directly above the wafer box, the transversing loading mechanism does not need to be adjusted horizontally, that is, the internal horizontal adjusting mechanism does not need to be operated. As shown in FIG. 1 to FIG. 2, the horizontal adjusting mechanism in the transversing loading mechanism does not extend to left or right, a transversing support plate (as shown in the slide rail structure in the previous embodiment) located below the picking-up and fixing mechanism 200-8 in the figure does not move left or right relative to the travelling base plate. In response to the wafer box being not directly below the overhead hoist vehicle, the horizontal adjusting mechanism adjusts its position in the horizontal plane according to the position of the wafer box. The synchronous adjusting mechanism shown in FIG. 3 drives the sliding mechanism to move to the left, so other components of the overhead hoist vehicle (e.g., lifting mechanism, clamping mechanism, vehicle body, etc.) installed below the transversing loading mechanism will move to the left accordingly, so that the components configured to grasp and clamp the wafer box to the space position directly above the wafer box.

It should be noted that only the schematic view of the horizontal adjusting mechanism moving to the left is shown, but the movement principle of the right movement is the same, and the right movement is not described here.

In some embodiments, a multi-stage sliding structure is used to form a sliding mechanism.

As shown in FIG. 4, the sliding mechanism includes a second stage plate 200-9, a third stage plate 200-10, and an angle adjusting base plate 200-11 (i.e., an angle adjustment component base plate, not distinguished below), multiple sliding blocks 200-6, and a sliding block coupler 200-3.

In some embodiments, the second stage plate 200-9 is connected to the inner lower part of the picking-up and fixing mechanism 200-8 by a corresponding sliding block 200-6. For example, the second stage plate 200-9 is connected to the lower surface of the sliding rail structure in the above embodiment through a corresponding sliding block 200-6, that is, the second stage plate 200-9 and the sliding rail structure serve as the transversing support structure of the entire sliding mechanism, which enhances structural strength and sliding effect.

The third stage plate 200-10 is connected to the lower part of the second stage plate 200-9 by a corresponding sliding block 200-6, and the angle adjusting base plate 200-11 is connected to the lower part of the third stage plate 200-10 by a corresponding sliding block 200-6.

The sliding block coupler 200-3 is connected to the synchronous adjusting mechanism, and is configured to drive the second stage plate 200-9 to move under the drive of the synchronous adjusting mechanism, which causes the second stage plate 200-9 to drive the third stage plate 200-10 to move, and the third stage plate 200-10 to drive the angle adjusting base plate 200-11 to move, so that the angle adjusting base plate 200-11 moves to a predetermined horizontal position in the horizontal direction.

In some embodiments, the sliding block coupler 200-3 is driven by the synchronous adjusting mechanism to cause the sliding mechanism composed of multi-stage plates to move in linkage, thereby adjusting the horizontal position.

In some embodiments, the synchronous adjusting mechanism adopts a synchronous wheel and belt structure as the core, to achieve multi base plate linkage movement through a simple structure.

As shown in FIG. 1 to FIG. 4, the synchronous adjusting mechanism includes a first synchronous wheel and belt 200-12, a second synchronous wheel and belt 200-13, and a first drive mechanism.

In some embodiments, the first drive mechanism is arranged on a side of the sliding mechanism (e.g., a lower side in the FIG. 2 or FIG. 3) to drive the sliding block coupler 200-3.

The first synchronous wheel and belt 200-12 and the second synchronous wheel and belt 200-13 are respectively arranged on two sides of the sliding mechanism (e.g., the upper side and the lower side in the FIG. 3).

Among them, a synchronous wheel of the first synchronous wheel and belt 200-12 is fixedly connected to the third stage plate 200-10, an upper belt of the first synchronous wheel and belt 200-12 is provided with a first belt seat, one side of the first belt seat is fixedly connected to the second stage plate 200-9, and the other side of the first belt seat is fixedly connected to the sliding block coupler 200-3, a lower belt of the first synchronous wheel and belt 200-12 is provided with a second belt seat fixedly connected to the angle adjusting base plate 200-11.

A synchronous wheel of the second synchronous wheel and belt 200-13 is fixedly connected to the second stage plate 200-9, and an upper belt of the second synchronous wheel and belt 200-13 is provided with a third belt seat fixedly connected to the bottom surface of the picking-up and fixing mechanism, and a lower belt of the second synchronous wheel and belt 200-13 is provided with a fourth belt seat fixedly connected to the third stage plate 200-10.

In this case, in response to the sliding block coupler 200-3 being driven by the first drive mechanism, the first synchronous wheel and belt 200-12 rotates, that is, the belt seat of the upper belt of the first synchronous wheel and belt 200-12 is driven to move. As one side of the belt seat of the upper belt of the first synchronous wheel and belt 200-12 is fixed on the second stage plate 200-9, the second stage plate 200-9 also moves. Meanwhile, due to the fact that the second synchronous wheel and belt 200-13 is fixed on the second stage plate 200-9, and the lower belt of the second synchronous wheel and belt 200-13 is fixed on the third stage plate 200-10 by a belt seat, the second stage plate 200-9 drives the third stage plate 200-10 to move. Moreover, due to the fact that the first synchronous wheel and belt 200-12 is fixed on the third stage plate 200-10, and the lower belt of the first synchronous wheel and belt 200-12 is fixed on the angle adjusting base plate 200-11 by a belt seat, the third stage plate 200-10 drives the angle adjusting base plate 200-11 to move, thereby adjusting the angle adjusting base plate 200-11 to the predetermined horizontal position in the horizontal direction.

It should be noted that FIG. 3 is a schematic illustration of moving to the left (relative to the view direction), but the principle of moving to the right is the same and will not be repeated here.

In some embodiments, a screw drive structure is used as the core of the first drive mechanism, which makes the structure reasonable and occupies less space.

As shown in FIG. 1 to FIG. 4, the first drive mechanism includes a first lead screw 200-14 and a first motor (i.e., a first motor installed at the lower right position in the FIG. 2 or FIG. 3), the sliding block coupler is sleeved on the first lead screw 200-14, and the output shaft of the first motor is connected to an end of the first lead screw to drive the first lead screw.

**In** some embodiments, a detection portion may be used.

As shown in FIG. 1 to FIG. 4, the horizontal adjusting mechanism further includes a first detection portion arranged on a side of the sliding mechanism (e.g., the first detection portion set at the lower position in the FIG. 3), and configured to detect a position of the sliding block coupler to detect a position of the transversing loading device in the horizontal direction.

**In** some embodiments, position limit detection can be performed on the maximum adjustment position of the horizontal position by setting multiple detectors in the first detection portion.

As shown in FIG. 1 to FIG. 4, the first detection portion includes a first sensor 200-4, a second sensor 200-1, and a third sensor 200-5 arranged in intervals along the sliding direction of the sliding mechanism. The first sensor 200-4 is configured to limit a leftmost position of the sliding block coupler 200-3 to along the first direction, the second sensor 200-1 is configured to limit an initial position of the sliding block coupler 200-3 along the first direction, the third sensor 200-5 is configured to limit a rightmost position of the sliding block coupler 200-3 along the first direction, and the initial position is an initial position where the sliding mechanism is returned.

In some embodiments, a detection plate 200-2 is arranged on the sliding block coupler 200-3, and the detection plate 200-2 is configured to cooperate with various sensors for detection.

In some embodiments, a rotating mechanism is used to adjust the angle of other components (e.g., the grasping mechanism, the lifting mechanism, vehicle body, etc.) of the overhead hoist vehicle in a horizontal plane, so that the overhead hoist vehicle can grasp the target object at an accurate angle which is not placed at the correct angle.

As shown in FIG. 1 to FIG. 5, the horizontal adjusting mechanism further includes a rotating mechanism 200-7 installed on the angle adjusting base plate 200-11 to rotate the overhead hoist vehicle.

In some embodiments, the rotating mechanism 200-7 includes a worm gear assembly and a rotating shaft 200-7-8. The worm gear assembly is configured to engage with the rotating shaft 200-7-8 to drive the rotating shaft 200-7-8 to rotate to a predetermined angle, thereby adjusting other components of the overhead hoist vehicle suspended below the rotating shaft 200-7-8 to an appropriate angle for easy grasping of the target object.

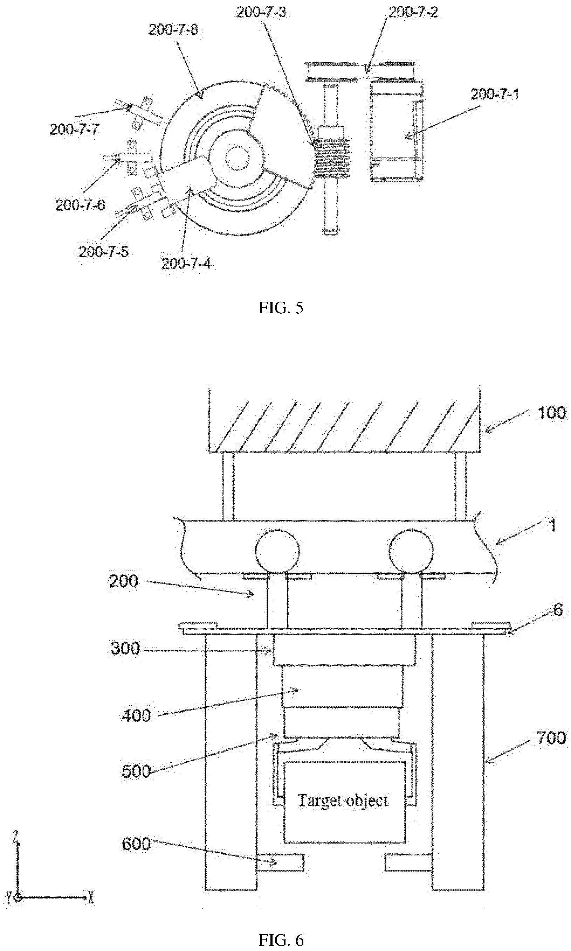

In some embodiments, as shown in FIG. 5 useful for understanding the present invention, the worm gear component adopts a structure of a motor cooperating with the worm to implement rotational drive, that is, the worm gear component includes a motor 200-7-1, a third synchronous wheel and belt 200-7-2, and a worm gear 200-7-3. The motor 200-7-1 is configured to drive the third synchronous wheel and belt 200-7-2 and the worm gear 200-7-3 to rotate the rotating shaft 200-7-8.

In some embodiments, multiple detectors can be arranged in the rotating mechanism 200-7 to perform position limit detection on the maximum adjustment position of the rotation angle.

As shown in FIG. 5 useful for understanding the present invention, the rotating mechanism 200-7 further includes a second detection portion configured to limit the rotation angle of the rotating shaft.

In some embodiments, the second detection portion includes a first detector 200-7-5, a second detector 200-7-6, and a third detector 200-7-7 sequentially spaced along the circumferential direction of the rotating shaft. The first detector 200-7-5 is configured to limit a maximum rotating angle of the rotating shaft 200-7-8 in counterclockwise in a horizontal plane, the second detector 200-7-6 is configured to limit an initial angle of the rotating shaft 200-7-8 in the horizontal plane, the third detector 200-7-7 is configured to limit a maximum rotating angle of the rotating shaft 200-7-8 in clockwise in the horizontal plane, and the initial angle is an initial angle of the sliding mechanism at which the sliding mechanism is returned.

In some embodiments, the detection plates 200-7-4 is arranged on the rotating shaft 200-7-8 to cooperate with various detectors for position limit detection. For example, in response to adjusting the detection plates 200-7-4 to be located on the first detector 200-7-5 or the third detector 200-7-7, a rotation angle in this case is the maximum rotation angle.

Based on the same invention concept, an overhead hoist vehicle is further provided according to the embodiments of the present application, to align the overhead hoist vehicle with the target directly below in a horizontal plane based on the transversing loading device (i.e., the transversing loading mechanism) provided according to any of the above embodiments.

As shown in FIG. 6, the overhead hoist vehicle includes: a travelling base plate 6, a travelling mechanism 200 installed on the surface of the travelling base plate, a transversing loading device 300 installed on a bottom surface of the travelling base plate. The transversing loading device 300 is a transversing loading device according to any one of above embodiments. The overhead hoist vehicle further includes a lifting mechanism 400 connected to a bottom surface of the transversing loading device; and a clamping mechanism 500 connected to the lifting mechanism by a lifting belt.

The travelling mechanism 200 is configured to drive the travelling base plate 6 to move on a travelling track 1(e.g., the track arranged below a ceiling 100) to reach a first preset position along a predetermined travel route, and the first preset position is arranged above a target object to be handled; the transversing loading device 300 is configured to enable the lifting mechanism 400 to be arranged directly above the target object in a horizontal plane, the lifting mechanism 400 is configured to enable the clamping mechanism 500 to move up and down, and the clamping mechanism 500 is configured to grasp and clamp the target object to move the target object to a second preset position.

In response to the travelling mechanism reaching a position above the target object according to the preset route, the lifting mechanism 400 and the clamping mechanism 500 move to the position directly above the target object in advance in the horizontal direction through the transversing loading device, which allows the target object to be grasped and clamped to be handled. The overhead hoist vehicle has a simple structure, high flexibility, high production efficiency, and is very easy to meet the needs of the factory.

It should be noted that components such as the travelling base plate, the travelling mechanism, the lifting mechanism, and the clamping mechanism 500 can be designed according to actual application requirements, which will not be limited hereto.

In some embodiments, various component mechanisms in the overhead hoist vehicle can be placed inside the vehicle body.

As shown in FIG. 6, the overhead hoist vehicle further includes a vehicle body 700, the top of which is fixedly connected to the lower surface of the travelling base plate 6, and the transversing loading device 300, lifting mechanism 400, and clamping mechanism 500 are all placed inside the vehicle body 700.

In some embodiments, a corresponding detection portion can be installed in the overhead hoist vehicle to detect a position mark arranged on the travelling track to accurately detect the position of the vehicle body.

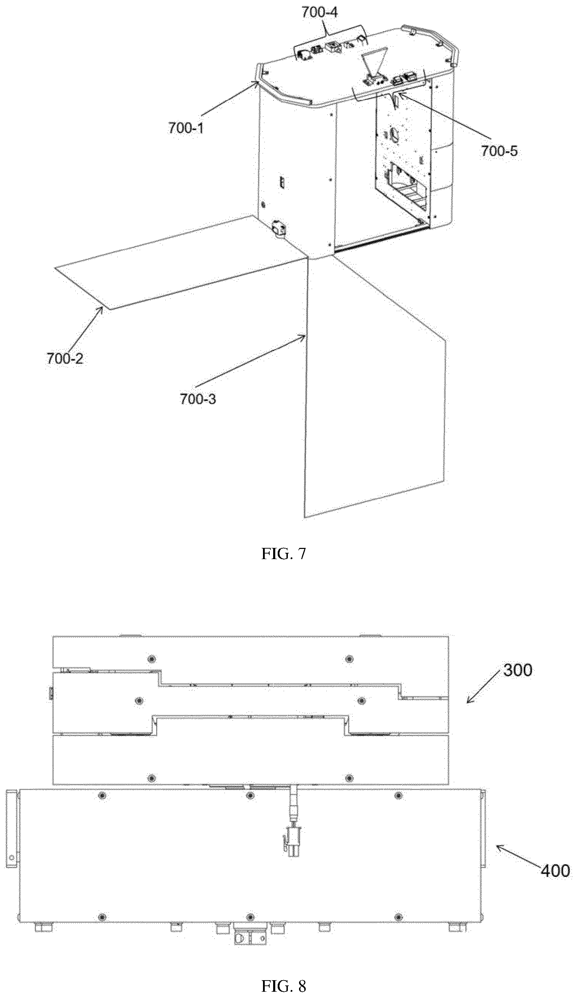

As shown in FIG. 7, the overhead hoist vehicle further includes position detection portions 700-4, 700-5 installed at a first top position of the vehicle body to detect a position mark to detect the position of the vehicle body. The first top position is defined at top two sides of the vehicle body 700-4 perpendicular to the extending direction of the travelling track, and the position mark is arranged on the travelling track.

In some embodiments, bumper strips are installed on the vehicle body to reduce the impact on production safety caused by collisions between adjacent overhead hoist vehicle, as well as collisions between the vehicle body and surrounding objects.

As shown in FIG. 7, the overhead hoist vehicle further includes a bumper strip 700-1 installed at a second top position of the vehicle body to provide collision proof between adjacent travelling mechanisms. The second top position is defined as top two sides of the vehicle body parallel to the extending direction of the travelling track.

In some embodiments, radars can be used to detect obstacles (e.g., moving or stationary objects, people, etc.) during travelling, to improve production safety.

As shown in FIG. 7, the overhead hoist vehicle further includes a first radar installed on the bottom surface of the vehicle body to detect first obstacles in the lower space of the vehicle body (as shown in area 700-3).

And/or, the overhead hoist vehicle further includes a second radar installed on a side surface of the vehicle body 700 and configured to detect second obstacles in a front space 700-2 of the vehicle body 700, and the front space 700-2 in defined as in front of the vehicle body 700 in response to the vehicle body 700 travelling (as shown in the area 700-2).

In some embodiments, an anti-drop mechanism can be used to protect the target object during transportation, to prevent the production safety being affected caused by the target object dropping.

As shown in FIG. 6 to FIG. 7, the overhead hoist vehicle further includes an anti-drop mechanism 600 installed inside the vehicle body (e.g., a lower space of the right vehicle body in FIG. 7). The anti-drop mechanism includes a first linkage bracket (e.g., the bracket extending below the target object in FIG. 6). In response to the target object being not grasped by the clamping mechanism 500, the first linkage bracket retracts inside the vehicle body 700, in response to the target object being grasped by the clamping mechanism 500, the first linkage bracket extends from inside of the vehicle body 700 to below the target object to prevent the target object from dropping.

It should be noted that the first linkage bracket may be a single arm structure, a triangular structure, a quadrilateral structure, or even a polygonal structure, which is not limited hereto.

In some embodiments, in response to an anti-drop mechanism being used to protect the target object during handling, a clamping structure is further used to abut against the target object in the anti-drop mechanism, which reduces the shaking of the target object and improves production safety.

In implementation, the anti-drop mechanism further includes the second linkage bracket, which is synchronously linked with the first linkage bracket. In response to the target object being not grasped by the clamping mechanism 500, the second linkage bracket retracts inside the vehicle body 700, in response to the target object being grasped by the clamping mechanism 500, the second linkage bracket extends from inside of the vehicle body 700 to be abut against the target object to prevent the target object from shaking.

It should be noted that the second linkage bracket may be a single arm structure, a triangular structure, a quadrilateral structure, or even a polygonal structure, which is not limited hereto. In addition, a structure of the second linkage bracket in contact with the target object may be cylindrical, spherical, planar, and other structures, which is not limited hereto.

In some embodiments, a rotating shaft is used to connect the lifting mechanism 400 to the transversing loading mechanism 300 to facilitate the horizontal angle adjustment of the transversing loading mechanism 300 to adjust the angle of the lifting mechanism 400, so that the lifting mechanism 400 can be quickly, smoothly, and accurately adjusted to the position directly above the target object.

As shown in FIG. 8, the lifting mechanism is connected to the lower surface of the transversing loading mechanism through a rotating shaft (as shown in the middle connection between the lifting mechanism and the transversing loading mechanism in the figure).

In order to facilitate the understanding of the overhead hoist vehicle (e.g., overhead travelling crane, without distinction below) provided according to the embodiments of the present application, the travelling mechanism, the clamping mechanism 500, and the anti-drop mechanism are described as follows.

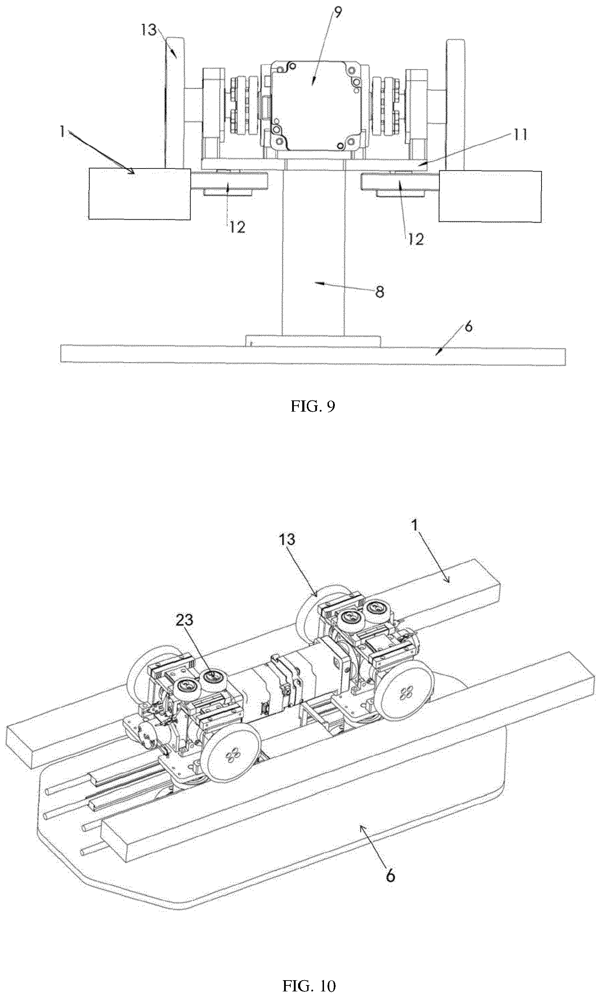

As shown in FIG. 9 to FIG. 12, in the travelling mechanism (i.e., the travelling device, without distinction below), a reducer 9, a servo motor, a travelling wheel group 13, an auxiliary wheel group 12 are installed on the travelling base plate 6 (i.e., the base plate travelling base plate, without distinction below) through the rotating shaft 8. The travelling wheel group 13 and the auxiliary wheel group 12 travel along a preset straight travelling track 1, and also travel along a curved travelling track 14-1 and a curved travelling track 14-2 under guiding of the guide travelling track 15 through the guide wheel group 23, so that the overhead hoist vehicle can move and handle objects along a preset route.

Specifically, the travelling device includes a travelling wheel group, a first base plate 11, and a drive mechanism. Among them, the travelling wheel group includes a travelling wheel group 13 and an auxiliary wheel group 12, and the drive mechanism includes a reducer 9 and a servo motor 10. The travelling wheel group 13 is connected to the output shaft of the reducer 9, the output shaft of the servo motor 10 is connected to the input shaft of the reducer 9, and the axial direction of the servo motor 10 is parallel to the travelling direction of the travelling track 1. The reducer 9 and the servo motor 10 are installed on the upper surface of the first base plate 11, and the auxiliary wheel group 12 is installed on the lower surface of the first base plate 11.

In this case, the servo motor 10 is configured to drive the reducer 9, and the reducer 9 is configured to drive travelling wheel group 13 arranged on two side of the travelling track 1, so that, the traveling wheel group 13 travel along a preset route on the travelling track 1, and the auxiliary wheel group 12 travels along an inner side of the travelling track 1 in response to the travelling wheel group 13 moves forward with the first base plate 11. Therefore, the entire travelling device will move steadily and reliably along the travelling track 1 under the action of the travelling wheel group 13 and the auxiliary wheel group 12.

In some embodiments, the axial direction of servo motor 10 is parallel to the travelling direction of the travelling track 1, so the servo motor 10 only occupies space perpendicular to the travelling direction. Moreover, a larger space can be reserved below the servo motor 10, which reduces the space occupied by the entire travelling device, reduces the turning radius, and allows for more installation space, thereby making it easier to install other components.

In some embodiments, the servo motor 10 may be preferably embodied as a commercially available universal flat servo motor, and the reducer 9 may be preferably embodied as a commercially available miniaturized universal reducer.

By selecting a universal reducer and a universal servo motor to drive the travelling wheel group, as well as setting the axial direction of the servo motor parallel to the travelling direction, the distance between the center and the motor during travelling is minimized, which reduces space occupation, saves space, and has a smaller turning radius during travelling. Additionally, there is no need for a customized reducer, and there is no need for special customization in component procurement, which achieves procurement convenience, easy installation and debugging, and is beneficial for deploying the overhead hoist vehicle in an automated factory.

In some embodiments, the first base plate 11 mentioned above can be connected to the travelling base plate to facilitate the suspension of other components, such as lifting portions, grasping portions, etc., through the travelling base plate during travelling.

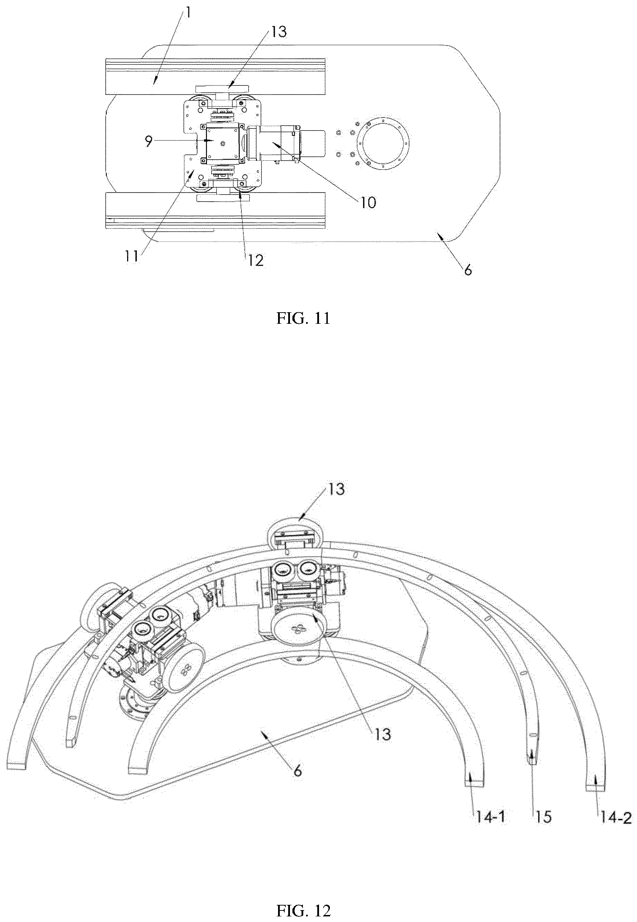

As shown in FIG. 9 and FIG. 11, the travelling device further includes a travelling base plate 6 and a rotating shaft 8, where the first base plate 11 is connected to the travelling base plate 6 through the rotating shaft 8, so that other components of the overhead hoist vehicle (not shown in the figure) can be installed through travelling base plate 6, such as a vehicle body suspended below the travelling base plate 6.

By using the rotating shaft 8 and the travelling base plate 6, it is not only convenient to install other components of the overhead hoist vehicle through the travelling base plate 6, but also convenient for the overhead hoist vehicle to smoothly travel and turn through the rotating shaft 8, thereby optimizing the travelling effect of the travelling device in different scenarios.

In some embodiments, high-frequency cables are laid in the travelling direction, and electricity can be drawn from the high-frequency cables to provide power for the travelling device.

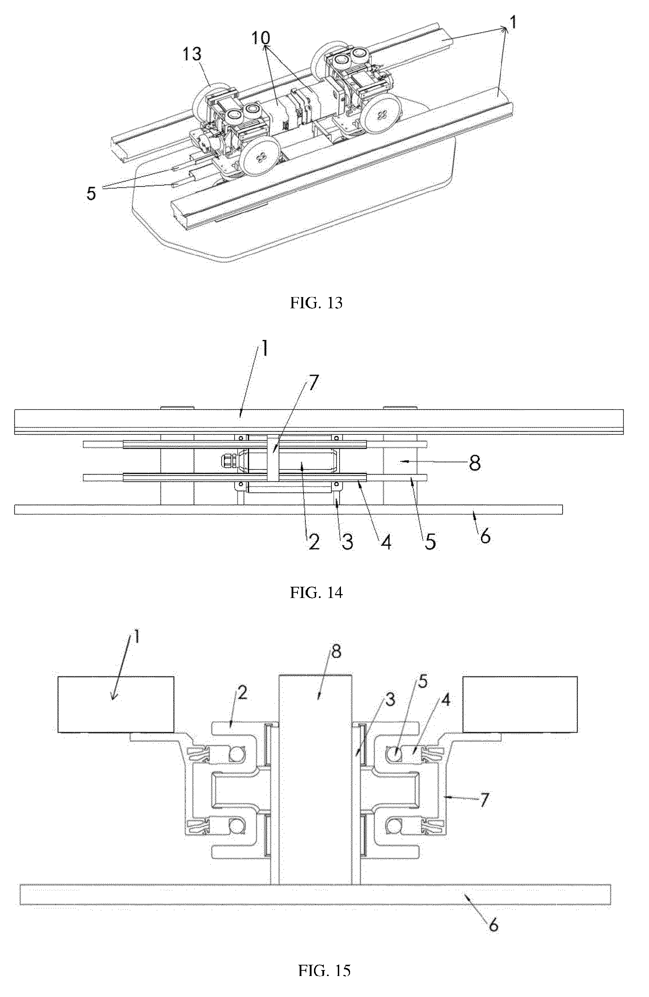

As shown in FIG. 13 to FIG. 15, the high-frequency cables 5 are fixed to the travelling track by a cable slot 4 and a high-frequency cable bracket 7. The travelling device further includes a wireless power receiving device (not shown separately in the figure) configured to provide power to the servo motor after wireless power is taken from the high-frequency cable 5.

In some embodiments, the wireless power receiving device is arranged in a reserved space below the servo motor 10.

As shown in FIG. 14 to 15, the travelling mechanism obtains power through non-contact means, that is, a power receiving device 2 is provided to obtain power from the high-frequency cable 5. Among them, the power receiving device 2 is an E-type power receiving device 2, and the power is obtained by cutting the magnetic field of the high-frequency cable 5 to provide power to the travelling mechanism.

The high-frequency cable 5 is fixed on the travelling track 1 by cable slot 4 and the high-frequency cable bracket 7, and the power receiving device 2 is fixed on the travelling base plate 6 by a power receiving device installation bracket 3. The power receiving device 2 is a separate structure from the rotating shaft 8, which makes the power receiving structure simpler, with higher space utilization, and also far away from surrounding metal components, thereby reducing heat generation and making the installation more flexible.

In some embodiments, the wireless power receiving device is installed on the upper surface of the travelling base plate 6, thereby being away from surrounding metal components, such as a predetermined distance from the rotating shaft, where the predetermined distance can refer to the distance at which the metal components have less impact on the wireless power receiving device.

The wireless power receiving device is a separate structure from the rotating shaft, which simplifies the structure and effectively improves space utilization. Moreover, the installation position of the wireless power receiving device is far from the metal components close to the travelling device, which can effectively reduce the influence of nearby metal components on the power receiving device and reduce the heating phenomenon of the power receiving device. In addition, the installation space is larger and more flexible, such as the reserved space below the servo motor 10.

In some embodiments, a steering mechanism is used to assist in controlling the travelling device to switch travelling tracks, move along curved travelling tracks.

As shown in FIG. 12 to FIG. 16, the travelling device further includes a steering control mechanism, which includes a rotating electromagnet 16, a toggle mechanism (not shown separately in the figure), and a slide rail 22. The travelling wheel group further includes a guide wheel group 23.

The guide wheel group 23 is installed on a sliding connection seat 21 of the slide rail 22, the slide rail 22 is installed on the top of the reducer 9, and the guide wheel group 23 is connected to the output shaft of the rotating electromagnet 16 through the toggle mechanism. The rotating electromagnet 16 is installed on a side of the reducer 9 (as shown in rear surface in the figure), the output shaft of the rotating electromagnet 16 is parallel to the axial direction of the servo motor 10, and the extending direction of the slide rail 22 is perpendicular to the axial direction of the servo motor 10.

In response to the overhead hoist vehicle changing its travelling route during operation, the rotating electromagnet 16 is configured to drive the toggle mechanism, and the guide wheel group 23 is driven by the toggle mechanism to move along the slide rail 22 to the first preset position, so that the guide wheel group 23 travels on the inner side of the guide rail 15 to follow a preset guiding route, while the travelling wheel group 13 and the auxiliary wheel group 12 travelling along the curved travelling track 14-1 and the curved travelling track 14-2, thereby changing rail and travelling in the curved travelling track with the assistance of the guide rail 15.

By horizontally arranging the rotating electromagnet 16, a vertical force transmission structure is horizontally arranged. While achieving the purpose of changing the travelling track, the entire steering power mechanism takes up less space. In response to the overhead hoist vehicle traveling around a curve, the interaction between the guide wheel group 23 and the guide rail 15 allows the travelling wheel group 13 on the outside of the curve to be suspended, that is, not in contact with the curved travelling track 14-2, to prevent the overhead hoist vehicle from getting stuck due to inconsistent speed between the inner and outer wheels, which ensures the normal operation of the overhead hoist vehicle.

It should be noted that the toggle mechanism is a mechanism capable of performing toggle, that is, the toggle mechanism can is configured to drive the guide wheel group 23 to move along the slide rail 22 under the drive of the rotating electromagnet 16. The toggle mechanism can be designed according to practical application needs to meet usage requirements.

In some embodiments, the rotating electromagnet 16 is installed on the reducer 9 through a mounting plate, for example, the rotating electromagnet 16 is fixed on the mounting plate 17, which is then fixed on the reducer 9, which simplifies the installation of the rotating electromagnet 16 and improves installation reliability.

In some embodiments, the toggle mechanism can be embodied as a simple structure.

In some embodiments, the toggle mechanism includes a lever 18, a cam follower 19, and a guide groove 20. One end of the lever 18 is connected to the output shaft of the rotating electromagnet 16, and the other end of the lever 18 is provided with a cam follower 19. The cam follower 19 is arranged inside the guide groove 20, which is fixed on the sliding connection seat 21 of the slide rail 22.

The lever, combined with the cam follower and the guide groove, achieves a toggle mechanism, which has a simple structure, occupies a smaller volume, and has a simpler control method, thereby ensuring reliable toggle operation.

In some embodiments, a detector is configured to detect the traveling wheel group in a curved travelling track, that is, the detector is configured to detect the traveling wheel group on an outer curved travelling track.

In some embodiments, the steering control mechanism further includes a third detection portion (not shown separately in the figure) configured to detect a position of the toggle mechanism and output a first detection signal, and the first detection signal is used to represent that whether the toggle mechanism moves to a second preset position of the toggle mechanism.

It should be noted that the second preset position can be the position of the guide wheel group 23 relative to the reducer 9 in response to the travelling track needing to be changed, which is no limited hereto.

By detecting whether the toggle mechanism has reached the second preset position, the possibility of jamming during turning can be reduced.

In some embodiments, sensors can be used to achieve the detection function of the first detection portion.

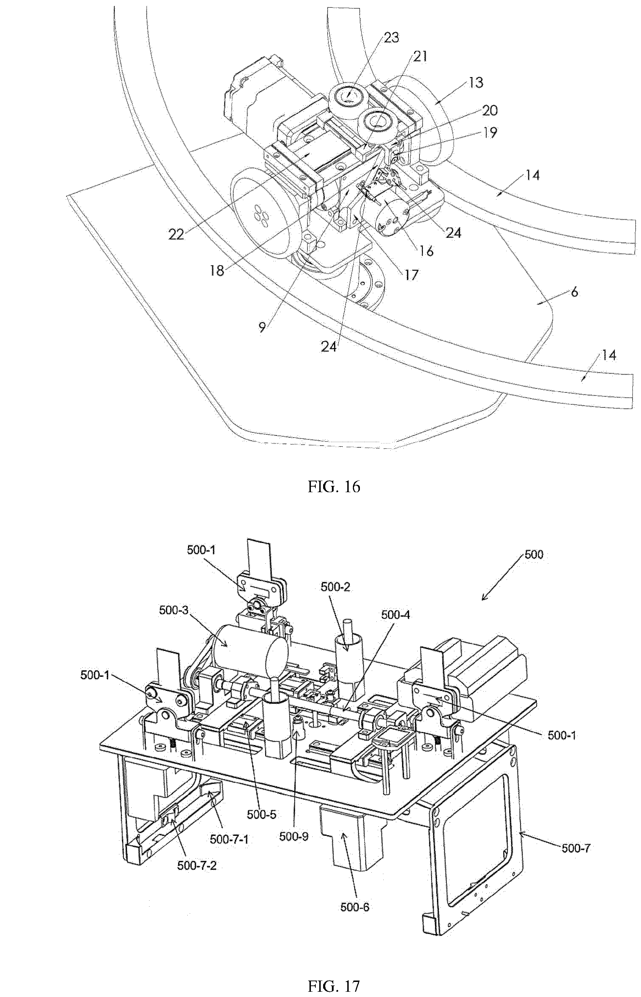

As shown in FIG. 16, the third detection portion includes a fourth sensor 24 and a first sensing plate. The fourth sensor 24 is installed on the rotating electromagnet 16 and remains relatively stationary with the rotating electromagnet 16. The first sensing plate is installed on the toggle mechanism (as shown in the detection plate installed on the lever 18 in the figure), and remains relatively stationary with the toggle mechanism, thereby triggering the fourth sensor to output the first detection signal in response to the first sensing plate moving with the toggle mechanism to the second preset position.

In some embodiments, the number of fourth sensors 24 is two, so that the two fourth sensors 24 can be distributed on two sides according to the needs of turning, and cooperate with the curved travelling track to detect the travelling wheel group 13 on the outer curved travelling track, thereby ensuring that the travelling wheel group 13 on the outer curved travelling track leaves the travelling track and preventing jamming faults during turning.

Based on the same invention concept, an overhead hoist vehicle is provided according to the embodiments of the present application based on any of the above embodiments.

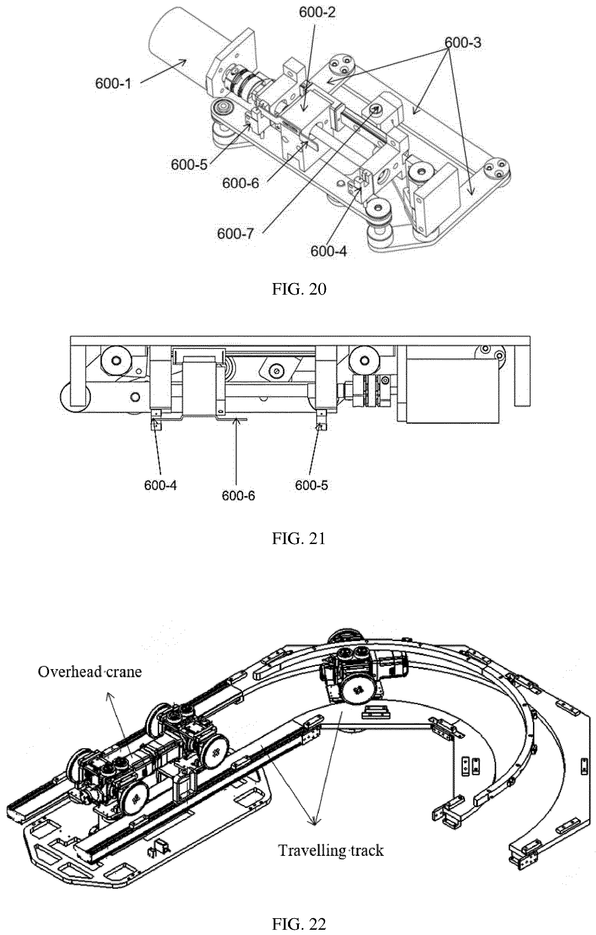

As shown in FIG. 22, the overhead hoist vehicle includes a travelling device and a vehicle body (not shown in the figure) as described in any of the above embodiments. The vehicle body is installed below the travelling device (e.g., below the base plate in the travelling device in the figure), and the travelling device travels along the travelling track to move the vehicle body to a designated position.

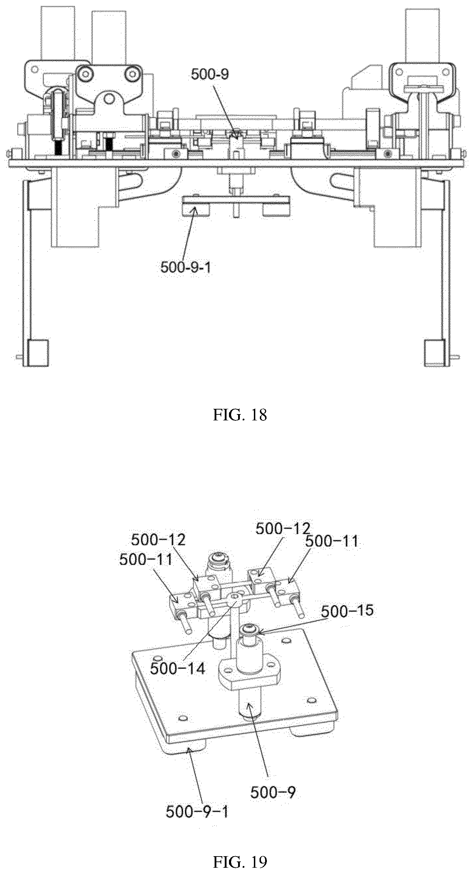

As shown in FIG. 17 to FIG. 19, the clamping mechanism 500 is connected to the lower part of the lifting mechanism 400 by a lifting belt adjustment component (500-1).

As shown in FIG. 17, the clamping mechanism 500 includes a positioning guide shaft 500-2 configured to position and guide a position in the lifting mechanism to lift the clamping mechanism to a designated position. The vertical positioning and guidance of the lifting process are carried out by the positioning guide shaft to improve production safety.

In response to both the transversing loading device 300 and the lifting mechanism 400 are in place, the motor 500-3 in the clamping mechanism 500 is configured to drive the left-right-hand lead screw 500-4 to translate the clamping jaws 500-7 on both sides on the slide rail 500-5, which completes the opening and closing of the clamping jaws 500-7 to grasp and release the target object.

The clamping mechanism 500 further includes positioning guide blocks 500-6, for example, four positioning guide blocks 500-6 are arranged around the clamping mechanism 500. During descending, the positioning guide blocks 500-6 are in contact with the top of the target object, which facilitates coarse guiding and positioning in the vertical direction during descending, thereby preventing the target object from tilting before being grasped.

In response to the target object being grasped by the clamping jaws 500-7, the structural design of the lower end of the clamping jaws 500-7 can be done with an inclined surface 500-7-1 according to the overall structural dimensions of the target object. The inclined surface 500-7-1 is used to horizontally coarse guide and position in response to the target object being grasped.

The middle lower part of the clamping jaws 500-7 can be designed according to the overall structural dimensions of the target object, such as a V-shaped positioning block 500-7-2 is provided. The V-shaped positioning block 500-7-2 can be used for precise horizontal positioning when grasping the target object.

By designing a positioning guide structure, the product can be accurately and smoothly clamped, which protects its stability and safety when being grasped.

In the figure, the clamping mechanism 500 further includes a spring positioning component 500-9, a first through-beam sensor 500-11, and a second through-beam sensor 500-12, which are configured to detect a position and perform position-limiting protection during descending.

For example, in response to the clamping mechanism 500 descending to a specified height, the positioning block 500-9-1 at the lower end of the spring positioning component is subjected to upward force from the target object, which causes the spring in the spring component to move up, so that the spring 500-15 in the spring component leaves the upper surface of the spring structure at a certain distance. Detection can be carried out through distance, such as using screws 500-14 to cooperate with two sets of through-beam sensors for detection and position-limiting protection. In this case, the beam from the first through-beam sensor 500-11 is obstructed and changes from on to off. As the clamping mechanism 500 continues to descend, the positioning block 500-9-1 at the lower end of the spring positioning component is subjected to upward force from the target object, which causes the spring in the spring component to continue to move upward. The beam from the second through-beam sensor 500-12 is obstructed and changes from on to off. In this case, the target object may be damaged due to excessive pressure from the positioning block 500-9-1 at the lower end of the spring positioning component caused by excessive lowering of the clamping mechanism 500. This situation is not allowed. Therefore, in response to the first through-beam sensor 500-11 being in the on state, it indicates that the clamping mechanism 500 has not lowered enough. In response to the second through-beam sensor 500-12 being in the off state, it indicates that the clamping mechanism 500 has dropped excessively. With detecting and position-limiting protection, the clamping jaws 500-7 can be lowered to a precise height without damaging the target object.

As shown in FIG. 20 to FIG. 21, the anti-drop mechanism 600 adopts an anti-drop structure with a quadrilateral linkage structure. After the clamping mechanism 500 accurately and smoothly clamps the object, the motor 600-1 in the anti-drop mechanism 600 on the inside of the vehicle body drives the ball screw to drive the sliding blocks 600-2 to rotate the connecting arms 600-3 of the first linkage mechanism, which are in an extended state to extend below the target object. Even if the target object drops from the clamping mechanism 500, the anti-drop mechanism 600 can stably and reliably catch the target object, which prevent the production safety from being affected caused by the target object dropping.

As shown in FIG. 20 to FIG. 21, a second linkage mechanism can be used to abut against the target object and reduce its shaking amplitude. For example, by using clamping blocks 600-7 on the second linkage mechanism, the target object can be firmly abutted against to prevent the target object from shaking or dropping.

As shown in FIG. 20 to FIG. 21, a detection portion can be used to detect and perform position-limiting in the extending or retracting of the anti-drop mechanism. For example, detection can be achieved through the cooperation of the sensor 600-4, the sensor 600-5, and the detection plate 600-6. In response to the detection plate 600-6 obstructing the sensor 600-4, it indicates that the anti-drop mechanism is fully retracted, and in response to the detection plate 600-6 obstructing the sensors 600-5, it indicates that the anti-drop mechanism is fully extended.

Based on the same inventive concept, an automatic material handling system is further provided according to the embodiments of the present application, to grasping and handling the target object using the overhead hoist vehicle (also known as a crane) provided based on any of the above embodiments.

In some embodiments, an automatic material handling system provided according to the present application includes: the overhead hoist vehicle described in any of the above embodiments and a travelling track installed under a ceiling.

As shown in FIG. 22, the overhead hoist vehicle (e.g., the overhead hoist vehicle in the figure) travels on the travelling track along the predetermined route to handle the target object.

It should also be noted that those of ordinary skills in the art can understand that in various embodiments of the present application, many technical details have been proposed to enable readers to better understand the present application.

The embodiments which fall under the scope of the claims are considered embodiments of the present invention. Other embodiments are examples useful for understanding the present invention.

## Claims

1. An overhead hoist vehicle, comprising:
a travelling base plate (6);
a travelling mechanism (200) installed on an upper surface of the travelling base plate (6);
a transversing loading device (300) installed on a bottom surface of the travelling base plate (6);
a lifting mechanism (400) connected to a bottom surface of the transversing loading device (300); and
a clamping mechanism (500) connected to the lifting mechanism (400) by a lifting belt;
wherein the transversing loading device (300) comprises:
a picking-up and fixing mechanism fixedly connected under a travelling base plate (6) of the overhead hoist vehicle; and
a horizontal adjusting mechanism installed on a bottom surface of the picking-up and fixing mechanism;
wherein the horizontal adjusting mechanism comprises a synchronous adjusting mechanism and a sliding mechanism, the synchronous adjusting mechanism is arranged on a side surface of the sliding mechanism and is configured to slidably adjust the sliding mechanism to a predetermined horizontal position relative to the travelling base plate (6) along a first direction, the first direction is a horizontal direction perpendicular to the side surface, and the predetermined horizontal position is a position above a target object to be handled;
wherein the travelling mechanism (200) is configured to drive the travelling base plate (6) to move on a travelling track to reach a first preset position along a predetermined travel route, and the first preset position is arranged above a target object to be handled; the transversing loading device (300) is configured to enable the lifting mechanism (400) to be arranged directly above the target object in a horizontal plane, the lifting mechanism (400) is configured to enable the clamping mechanism (500) to move up and down, and the clamping mechanism (500) is configured to grasp and clamp the target object to move the target object to a second preset position;
wherein the travelling mechanism (200) further comprises a first base plate (11), a drive mechanism, a travelling wheel group (13) and an auxiliary wheel group (12), and the drive mechanism comprises a reducer (9) and a servo motor (10);
the travelling wheel group (13) is connected to an output shaft of the reducer (9), an output shaft of the servo motor (10) is connected to an input shaft of the reducer (9), and an axial direction of the servo motor (10) is parallel to a travelling direction of the travelling track;
the reducer (9) and the servo motor (10) are installed on an upper surface of the first base plate (11), and the auxiliary wheel group (12) is installed on a lower surface of the first base plate (11);
the first base plate (11) is connected to the travelling base plate (6) and is located above the travelling base plate (6); and
the servo motor (10) is configured to drive the reducer (9), to drive the travelling wheel group (13) to move on the travelling track along the predetermined travel route, and the auxiliary wheel group (12) is configured to travel along an inner side of the travelling track;
**characterized in that**
the travelling mechanism (200) further comprises a steering control mechanism, the steering control mechanism comprises a rotating electromagnet (16), a toggle mechanism, and a slide rail (22), and the travelling wheel group further comprises a guide wheel group (23); and
wherein the guide wheel group (23) is installed on a sliding connection seat of the slide rail (22), the slide rail is installed on top of the reducer (9), the guide wheel group (23) is connected to an output shaft of the rotating electromagnet (16) by the toggle mechanism, and the rotating electromagnetic (16) is installed on a side of the reducer (9); the output shaft of the rotating electromagnet (16) is parallel to an axial direction of the servo motor (10), and an extending direction of the slide rail (22) is perpendicular to the axial direction of the servo motor (10);
the travelling mechanism is configured such that in response to the toggle mechanism being driven by the rotating electromagnet (16), the guide wheel group (23) moves along the slide rail (22) to the first preset position driven by the toggle mechanism, so that the guide wheel group (23) travels on the inner side of the guide rail (15) along a preset guide travelling track.

2. The overhead hoist vehicle according to claim 1, wherein the sliding mechanism comprises a second stage plate (200-9), a third stage plate (200-10), an angle adjusting base plate (200-11), a plurality of sliding blocks (200-6), and a sliding block coupler (200-3);
wherein the second stage plate (200-9) is connected to a lower part inside the picking-up and fixing mechanism by the plurality of sliding blocks (200-6);
wherein the third stage plate (200-10) is connected under the second stage plate (200-9) by the plurality of sliding blocks (200-6);
wherein the angle adjusting base plate (200-11) is connected under the third stage plate (200-10) by the plurality of sliding blocks (200-6); and
wherein the sliding block coupler (200-3) is connected to the synchronous adjusting mechanism to drive the second stage plate (200-9) to move, the second stage plate (200-9) drives the third stage plate (200-10) to move, the third stage plate (200-10) drives the angle adjusting base plate (200-11) to move, to enable the angle adjusting base plate (200-11) to be at the predetermined horizontal position along the first direction.

3. The overhead hoist vehicle according to claim 2, wherein the synchronous adjusting mechanism comprises a first synchronous wheel and belt (200-12), a second synchronous wheel and belt (200-13), and a first drive mechanism;
wherein the first drive mechanism is arranged on a side of the sliding mechanism to drive the sliding block coupler (200-3);
wherein the first synchronous wheel and belt (200-12) and the second synchronous wheel and belt (200-13) are arranged on two sides of the sliding mechanism, respectively;
wherein a synchronous wheel of the first synchronous wheel and belt (200-12) is fixedly connected to the third stage plate (200-10), an upper belt of the first synchronous wheel and belt (200-12) is provided with a first belt seat, one side of the first belt seat is fixedly connected to the second stage plate (200-9), and the other side of the first belt seat is fixedly connected to the sliding block coupler (200-3), a lower belt of the first synchronous wheel and belt (200-12) is provided with a second belt seat fixedly connected to the angle adjusting base plate (200-11); and
wherein a synchronous wheel of the second synchronous wheel and belt (200-13) is fixedly connected to the second stage plate (200-9), and an upper belt of the second synchronous wheel and belt (200-13) is provided with a third belt seat fixedly connected to the bottom surface of the picking-up and fixing mechanism, and a lower belt of the second synchronous wheel and belt (200-13) is provided with a fourth belt seat fixedly connected to the third stage plate (200-10).

4. The overhead hoist vehicle according to claim 3, wherein the first drive mechanism comprises a first lead screw (200-14) and a first motor, the sliding block coupler (200-3) is sleeved on the first lead screw (200-14), and an output shaft of the first motor is connected to an end of the first lead screw (200-14) to drive the first lead screw (200-14).

5. The overhead hoist vehicle according to claim 1, wherein the steering control mechanism further comprises a first detection portion configured to detect a position of the toggle mechanism and output a first detection signal, and the first detection signal is used to represent that whether the toggle mechanism moves to the second preset position of the toggle mechanism or not; and
wherein the first detection portion comprises a first sensor (24) and a first sensing plate, the first sensor (24) is installed on the rotating electromagnet (16), and the first sensing plate is installed on the toggle mechanism to trigger the first sensor to output the first detection signal in response to the first sensing plate travelling with the toggle mechanism.

6. The overhead hoist vehicle according to any one of claims 1 to 5, wherein the travelling mechanism (200) further comprises a rotating shaft (8), and the first base plate (11) is connected to the travelling base plate (6) by the rotating shaft (8);
wherein the travelling mechanism (200) further comprises a wireless power receiving device configured to provide power to the servo motor (10) after wirelessly receiving power from a high-frequency cable (5); and
wherein the wireless power receiving device is installed on an upper surface of the travelling base plate (6) to be at a predetermined distance from the rotating shaft (8).

7. The overhead hoist vehicle according to any one of claims 1 to 6, further comprising a vehicle body (700), wherein a top of the vehicle body (700) is fixedly connected to a lower surface of the travelling base plate (6), and the transversing loading device (300), the lifting mechanism (400), and the clamping mechanism (500) are all arranged inside the vehicle body (700); and
wherein the overhead hoist vehicle further comprises a bumper strip (700-1) installed at a second top position of the vehicle body (700) and configured to provide collision proof between two adjacent travelling mechanisms (200), and the second top position is defined at top two sides of the vehicle body (700) parallel to the extending direction of the travelling track.

8. The overhead hoist vehicle according to claim 7, further comprising an anti-drop mechanism (600) installed inside the vehicle body (700);
wherein the anti-drop mechanism (600) comprises a first linkage bracket, in response to the target object being not grasped by the clamping mechanism (500), the first linkage bracket retracts inside the vehicle body (700), in response to the target object being grasped by the clamping mechanism (500), the first linkage bracket extends from inside of the vehicle body (700) to below the target object to prevent the target object from dropping.

9. The overhead hoist vehicle according to claim 8, wherein the anti-drop mechanism (600) further comprises a second linkage bracket synchronously linked with the first linkage bracket, in response to the target object being not grasped by the clamping mechanism (500), the second linkage bracket retracts inside the vehicle body (700), in response to the target object being grasped by the clamping mechanism (500), the second linkage bracket extends from inside of the vehicle body (700) to be abut against the target object to prevent the target object from shaking.

10. The overhead hoist vehicle according to claim 1, wherein the lifting mechanism (400) is connected to a lower surface of the transversing loading device (300) by a rotating shaft (8).

## Patentansprüche

1. Überkopf-Hubfahrzeug, umfassend:
eine Fahrbasisplatte (6);
einen Fahrmechanismus (200), der an einer oberen Fläche der Fahrbasisplatte (6) angebracht ist;
eine Querladevorrichtung (300), die an einer Unterseite der Fahrbasisplatte (6) angebracht ist;
einen Hebemechanismus (400), der mit einer Unterseite der Querladevorrichtung (300) verbunden ist; und
einen Klemmmechanismus (500), der über einen Hubriemen mit dem Hebemechanismus (400) verbunden ist;
wobei die Querladevorrichtung (300) umfasst:
einen Aufnahme- und Befestigungsmechanismus, der fest unter einer Fahrbasisplatte (6) des Überkopf-Hubfahrzeugs verbunden ist; und
einen Horizontaleinstellmechanismus, der an einer Unterseite des Aufnahme- und Befestigungsmechanismus angebracht ist;
wobei der Horizontaleinstellmechanismus einen Synchroneinstellmechanismus und einen Gleitmechanismus umfasst, wobei der Synchroneinstellmechanismus an einer Seitenfläche des Gleitmechanismus angeordnet ist und dazu ausgebildet ist, den Gleitmechanismus gleitend auf eine vorbestimmte Horizontalposition relativ zur Fahrbasisplatte (6) entlang einer ersten Richtung einzustellen, wobei die erste Richtung eine zur Seitenfläche senkrechte Horizontalrichtung ist und die vorbestimmte Horizontalposition eine Position oberhalb eines zu handhabenden Zielobjekts ist;
wobei der Fahrmechanismus (200) dazu ausgebildet ist, die Fahrbasisplatte (6) anzutreiben, sich auf einer Fahrbahn entlang einer vorbestimmten Fahrstrecke zu bewegen, um eine erste voreingestellte Position zu erreichen, und die erste voreingestellte Position oberhalb eines zu handhabenden Zielobjekts angeordnet ist;
wobei die Querladevorrichtung (300) dazu ausgebildet ist, es dem Hebemechanismus (400) zu ermöglichen, in einer Horizontalebene direkt oberhalb des Zielobjekts angeordnet zu sein, der Hebemechanismus (400) dazu ausgebildet ist, es dem Klemmmechanismus (500) zu ermöglichen, sich auf und ab zu bewegen, und der Klemmmechanismus (500) dazu ausgebildet ist, das Zielobjekt zu greifen und zu klemmen, um das Zielobjekt in eine zweite voreingestellte Position zu bewegen;
wobei der Fahrmechanismus (200) ferner eine erste Basisplatte (11), einen Antriebsmechanismus, eine Laufradgruppe (13) und eine Hilfsradgruppe (12) umfasst, und der Antriebsmechanismus ein Untersetzungsgetriebe (9) und einen Servomotor (10) umfasst;
die Laufradgruppe (13) mit einer Abtriebswelle des Untersetzungsgetriebes (9) verbunden ist, eine Abtriebswelle des Servomotors (10) mit einer Eingangswelle des Untersetzungsgetriebes (9) verbunden ist, und eine Axialrichtung des Servomotors (10) parallel zu einer Fahrtrichtung der Fahrbahn ist;
das Untersetzungsgetriebe (9) und der Servomotor (10) an einer oberen Fläche der ersten Basisplatte (11) angebracht sind, und die Hilfsradgruppe (12) an einer unteren Fläche der ersten Basisplatte (11) angebracht ist;
die erste Basisplatte (11) mit der Fahrbasisplatte (6) verbunden ist und oberhalb der Fahrbasisplatte (6) angeordnet ist; und
der Servomotor (10) dazu ausgebildet ist, das Untersetzungsgetriebe (9) anzutreiben, um die Laufradgruppe (13) anzutreiben, sich auf der Fahrbahn entlang der vorbestimmten Fahrstrecke zu bewegen, und die Hilfsradgruppe (12) dazu ausgebildet ist, sich entlang einer Innenseite der Fahrbahn zu bewegen;
**dadurch gekennzeichnet, dass**
der Fahrmechanismus (200) ferner einen Lenksteuermechanismus umfasst, wobei der Lenksteuermechanismus einen Drehelektromagneten (16), einen Kippmechanismus und eine Gleitschiene (22) umfasst, und die Laufradgruppe ferner eine Führungsradgruppe (23) umfasst; und
wobei die Führungsradgruppe (23) an einem Gleitverbindungssitz der Gleitschiene (22) angebracht ist, die Gleitschiene auf der Oberseite des Untersetzungsgetriebes (9) angebracht ist, die Führungsradgruppe (23) über den Kippmechanismus mit einer Abtriebswelle des Drehelektromagneten (16) verbunden ist, und der Drehelektromagnet (16) an einer Seite des Untersetzungsgetriebes (9) angebracht ist;
wobei die Abtriebswelle des Drehelektromagneten (16) parallel zu einer Axialrichtung des Servomotors (10) ist, und eine Erstreckungsrichtung der Gleitschiene (22) senkrecht zur Axialrichtung des Servomotors (10) ist;
wobei der Fahrmechanismus derart ausgebildet ist, dass
als Reaktion darauf, dass der Kippmechanismus durch den Drehelektromagneten (16) angetrieben wird, sich die Führungsradgruppe (23) entlang der Gleitschiene (22) bis zur ersten voreingestellten Position bewegt, angetrieben durch den Kippmechanismus, so dass sich die Führungsradgruppe (23) auf der Innenseite der Führungsschiene (15) entlang einer voreingestellten Führungsfahrbahn bewegt.

2. Überkopf-Hubfahrzeug nach Anspruch 1, wobei der Gleitmechanismus eine zweite Stufenplatte (200-9), eine dritte Stufenplatte (200-10), eine Winkeleinstell-Basisplatte (200-11), eine Vielzahl von Gleitblöcken (200-6) und einen Gleitblockkoppler (200-3) umfasst;
wobei die zweite Stufenplatte (200-9) über die Vielzahl von Gleitblöcken (200-6) mit einem unteren Teil im Inneren des Aufnahme- und Befestigungsmechanismus verbunden ist;
wobei die dritte Stufenplatte (200-10) über die Vielzahl von Gleitblöcken (200-6) unter der zweiten Stufenplatte (200-9) verbunden ist;
wobei die Winkeleinstell-Basisplatte (200-11) über die Vielzahl von Gleitblöcken (200-6) unter der dritten Stufenplatte (200-10) verbunden ist; und
wobei der Gleitblockkoppler (200-3) mit dem Synchroneinstellmechanismus verbunden ist, um die zweite Stufenplatte (200-9) zum Bewegen anzutreiben, die zweite Stufenplatte (200-9) die dritte Stufenplatte (200-10) zum Bewegen antreibt, die dritte Stufenplatte (200-10) die Winkeleinstell-Basisplatte (200-11) zum Bewegen antreibt, um es der Winkeleinstell-Basisplatte (200-11) zu ermöglichen, sich an der vorbestimmten Horizontalposition entlang der ersten Richtung zu befinden.

3. Überkopf-Hubfahrzeug nach Anspruch 2, wobei der Synchroneinstellmechanismus eine erste Synchronrad-und-Riemen-Anordnung (200-12), eine zweite Synchronrad-und-Riemen-Anordnung (200-13) und einen ersten Antriebsmechanismus umfasst;
wobei der erste Antriebsmechanismus an einer Seite des Gleitmechanismus angeordnet ist, um den Gleitblockkoppler (200-3) anzutreiben;
wobei die erste Synchronrad-und-Riemen-Anordnung (200-12) und die zweite Synchronrad-und-Riemen-Anordnung (200-13) jeweils an zwei Seiten des Gleitmechanismus angeordnet sind;
wobei ein Synchronrad der ersten Synchronrad-und-Riemen-Anordnung (200-12) fest mit der dritten Stufenplatte (200-10) verbunden ist, ein oberer Riemen der ersten Synchronrad-und-Riemen-Anordnung (200-12) mit einem ersten Riemensitz versehen ist, eine Seite des ersten Riemensitzes fest mit der zweiten Stufenplatte (200-9) verbunden ist, und die andere Seite des ersten Riemensitzes fest mit dem Gleitblockkoppler (200-3) verbunden ist, ein unterer Riemen der ersten Synchronrad-und-Riemen-Anordnung (200-12) mit einem zweiten Riemensitz versehen ist, der fest mit der Winkeleinstell-Basisplatte (200-11) verbunden ist; und
wobei ein Synchronrad der zweiten Synchronrad-und-Riemen-Anordnung (200-13) fest mit der zweiten Stufenplatte (200-9) verbunden ist, und ein oberer Riemen der zweiten Synchronrad-und-Riemen-Anordnung (200-13) mit einem dritten Riemensitz versehen ist, der fest mit der Unterseite des Aufnahme- und Befestigungsmechanismus verbunden ist, und ein unterer Riemen der zweiten Synchronrad-und-Riemen-Anordnung (200-13) mit einem vierten Riemensitz versehen ist, der fest mit der dritten Stufenplatte (200-10) verbunden ist.

4. Überkopf-Hubfahrzeug nach Anspruch 3, wobei der erste Antriebsmechanismus eine erste Leitspindel (200-14) und einen ersten Motor umfasst, der Gleitblockkoppler (200-3) auf die erste Leitspindel (200-14) aufgeschoben ist, und eine Abtriebswelle des ersten Motors mit einem Ende der ersten Leitspindel (200-14) verbunden ist, um die erste Leitspindel (200-14) anzutreiben.

5. Überkopf-Hubfahrzeug nach Anspruch 1, wobei der Lenksteuermechanismus ferner einen ersten Erfassungsabschnitt umfasst, der dazu ausgebildet ist, eine Position des Kippmechanismus zu erfassen und ein erstes Erfassungssignal auszugeben, und das erste Erfassungssignal dazu dient, anzugeben, ob sich der Kippmechanismus zur zweiten voreingestellten Position des Kippmechanismus bewegt oder nicht; und
wobei der erste Erfassungsabschnitt einen ersten Sensor (24) und eine erste Sensorplatte umfasst, der erste Sensor (24) am Drehelektromagneten (16) angebracht ist, und die erste Sensorplatte am Kippmechanismus angebracht ist, um den ersten Sensor dazu zu veranlassen, das erste Erfassungssignal auszugeben, als Reaktion darauf, dass sich die erste Sensorplatte mit dem Kippmechanismus bewegt.

6. Überkopf-Hubfahrzeug nach einem der Ansprüche 1 bis 5, wobei der Fahrmechanismus (200) ferner eine Drehwelle (8) umfasst, und die erste Basisplatte (11) über die Drehwelle (8) mit der Fahrbasisplatte (6) verbunden ist;
wobei der Fahrmechanismus (200) ferner eine drahtlose Energieempfangsvorrichtung umfasst, die dazu ausgebildet ist, dem Servomotor (10) Energie bereitzustellen, nachdem drahtlos Energie von einem Hochfrequenzkabel (5) empfangen wurde; und
wobei die drahtlose Energieempfangsvorrichtung an einer oberen Fläche der Fahrbasisplatte (6) angebracht ist, um sich in einem vorbestimmten Abstand von der Drehwelle (8) zu befinden.

7. Überkopf-Hubfahrzeug nach einem der Ansprüche 1 bis 6, ferner umfassend einen Fahrzeugkörper (700), wobei ein oberer Teil des Fahrzeugkörpers (700) fest mit einer unteren Fläche der Fahrbasisplatte (6) verbunden ist, und die Querladevorrichtung (300), der Hebemechanismus (400) und der Klemmmechanismus (500) alle im Inneren des Fahrzeugkörpers (700) angeordnet sind; und
wobei das Überkopf-Hubfahrzeug ferner eine Stoßleiste (700-1) umfasst, die an einer zweiten oberen Position des Fahrzeugkörpers (700) angebracht ist und dazu ausgebildet ist, einen Kollisionsschutz zwischen zwei benachbarten Fahrmechanismen (200) bereitzustellen, und die zweite obere Position an den oberen zwei Seiten des Fahrzeugkörpers (700) parallel zur Erstreckungsrichtung der Fahrbahn definiert ist.

8. Überkopf-Hubfahrzeug nach Anspruch 7, ferner umfassend einen Herabfallsicherungsmechanismus (600), der im Inneren des Fahrzeugkörpers (700) angebracht ist;
wobei der Herabfallsicherungsmechanismus (600) einen ersten Koppelbügel umfasst, wobei sich als Reaktion darauf, dass das Zielobjekt nicht vom Klemmmechanismus (500) gegriffen wird, der erste Koppelbügel in das Innere des Fahrzeugkörpers (700) zurückzieht, wobei sich als Reaktion darauf, dass das Zielobjekt vom Klemmmechanismus (500) gegriffen wird, der erste Koppelbügel vom Inneren des Fahrzeugkörpers (700) bis unter das Zielobjekt erstreckt, um zu verhindern, dass das Zielobjekt herabfällt.

9. Überkopf-Hubfahrzeug nach Anspruch 8, wobei der Herabfallsicherungsmechanismus (600) ferner einen zweiten Koppelbügel umfasst, der synchron mit dem ersten Koppelbügel gekoppelt ist, wobei sich als Reaktion darauf, dass das Zielobjekt nicht vom Klemmmechanismus (500) gegriffen wird, der zweite Koppelbügel in das Innere des Fahrzeugkörpers (700) zurückzieht, wobei sich als Reaktion darauf, dass das Zielobjekt vom Klemmmechanismus (500) gegriffen wird, der zweite Koppelbügel vom Inneren des Fahrzeugkörpers (700) erstreckt, um gegen das Zielobjekt anzuliegen, um zu verhindern, dass das Zielobjekt wackelt.

10. Überkopf-Hubfahrzeug nach Anspruch 1, wobei der Hebemechanismus (400) über eine Drehwelle (8) mit einer unteren Fläche der Querladevorrichtung (300) verbunden ist.

## Revendications

1. Véhicule de levage suspendu, comprenant :
une plaque de base mobile (6) ;
un mécanisme de déplacement (200) installé sur une surface supérieure de la plaque de base mobile (6) ;
un dispositif de chargement transversal (300) installé sur une face inférieure de la plaque de base mobile (6) ;
un mécanisme de levage (400) relié à une face inférieure du dispositif de chargement transversal (300) ; et
un mécanisme de serrage (500) relié au mécanisme de levage (400) par une courroie de levage ;
dans lequel le dispositif de chargement transversal (300) comprend :
un mécanisme de préhension et de fixation relié de manière fixe sous une plaque de base mobile (6) du véhicule de levage suspendu ; et
un mécanisme de réglage horizontal installé sur une face inférieure du mécanisme de préhension et de fixation ;
dans lequel le mécanisme de réglage horizontal comprend un mécanisme de réglage synchrone et un mécanisme de glissement, le mécanisme de réglage synchrone est agencé sur une surface latérale du mécanisme de glissement et est configuré pour régler par glissement le mécanisme de glissement à une position horizontale prédéterminée par rapport à la plaque de base mobile (6) selon une première direction, la première direction étant une direction horizontale perpendiculaire à la surface latérale, et la position horizontale prédéterminée étant une position au-dessus d'un objet cible à manipuler ;
dans lequel le mécanisme de déplacement (200) est configuré pour entraîner la plaque de base mobile (6) à se déplacer sur une voie de déplacement afin d'atteindre une première position préréglée le long d'un trajet de déplacement prédéterminé, et la première position préréglée est agencée au-dessus d'un objet cible à manipuler ; le dispositif de chargement transversal (300) est configuré pour permettre au mécanisme de levage (400) d'être agencé directement au-dessus de l'objet cible dans un plan horizontal, le mécanisme de levage (400) est configuré pour permettre au mécanisme de serrage (500) de se déplacer de haut en bas, et le mécanisme de serrage (500) est configuré pour saisir et serrer l'objet cible afin de déplacer l'objet cible vers une deuxième position préréglée ;
dans lequel le mécanisme de déplacement (200) comprend en outre une première plaque de base (11), un mécanisme d'entraînement, un groupe de roues de roulement (13) et un groupe de roues auxiliaires (12), et le mécanisme d'entraînement comprend un réducteur (9) et un servomoteur (10) ;
le groupe de roues de roulement (13) est relié à un arbre de sortie du réducteur (9), un arbre de sortie du servomoteur (10) est relié à un arbre d'entrée du réducteur (9), et une direction axiale du servomoteur (10) est parallèle à une direction de déplacement de la voie de déplacement ;
le réducteur (9) et le servomoteur (10) sont installés sur une surface supérieure de la première plaque de base (11), et le groupe de roues auxiliaires (12) est installé sur une surface inférieure de la première plaque de base (11) ;
la première plaque de base (11) est reliée à la plaque de base mobile (6) et est située au-dessus de la plaque de base mobile (6) ; et
le servomoteur (10) est configuré pour entraîner le réducteur (9), afin d'entraîner le groupe de roues de roulement (13) à se déplacer sur la voie de déplacement le long du trajet de déplacement prédéterminé, et le groupe de roues auxiliaires (12) est configuré pour se déplacer le long d'un côté intérieur de la voie de déplacement ;
**caractérisé en ce que**
le mécanisme de déplacement (200) comprend en outre un mécanisme de commande de direction, le mécanisme de commande de direction comprend un électro-aimant rotatif (16), un mécanisme à bascule et un rail de glissement (22), et le groupe de roues de roulement comprend en outre un groupe de roues de guidage (23) ; et
dans lequel le groupe de roues de guidage (23) est installé sur un siège de raccordement coulissant du rail de glissement (22), le rail de glissement est installé sur le dessus du réducteur (9), le groupe de roues de guidage (23) est relié à un arbre de sortie de l'électro-aimant rotatif (16) par le mécanisme à bascule, et l'électro-aimant rotatif (16) est installé sur un côté du réducteur (9) ; l'arbre de sortie de l'électro-aimant rotatif (16) est parallèle à une direction axiale du servomoteur (10), et une direction d'extension du rail de glissement (22) est perpendiculaire à la direction axiale du servomoteur (10) ;
le mécanisme de déplacement est configuré de telle sorte que
en réponse à l'entraînement du mécanisme à bascule par l'électro-aimant rotatif (16), le groupe de roues de guidage (23) se déplace le long du rail de glissement (22) jusqu'à la première position préréglée sous l'entraînement du mécanisme à bascule, de sorte que le groupe de roues de guidage (23) se déplace sur le côté intérieur du rail de guidage (15) le long d'une voie de déplacement de guidage préréglée.

2. Le véhicule de levage suspendu selon la revendication 1, dans lequel le mécanisme de glissement comprend une plaque de deuxième étage (200-9), une plaque de troisième étage (200-10), une plaque de base de réglage d'angle (200-11), une pluralité de blocs coulissants (200-6) et un coupleur de bloc coulissant (200-3) ;
dans lequel la plaque de deuxième étage (200-9) est reliée à une partie inférieure à l'intérieur du mécanisme de préhension et de fixation par la pluralité de blocs coulissants (200-6) ;
dans lequel la plaque de troisième étage (200-10) est reliée sous la plaque de deuxième étage (200-9) par la pluralité de blocs coulissants (200-6) ;
dans lequel la plaque de base de réglage d'angle (200-11) est reliée sous la plaque de troisième étage (200-10) par la pluralité de blocs coulissants (200-6) ; et
dans lequel le coupleur de bloc coulissant (200-3) est relié au mécanisme de réglage synchrone pour entraîner la plaque de deuxième étage (200-9) à se déplacer, la plaque de deuxième étage (200-9) entraîne la plaque de troisième étage (200-10) à se déplacer, la plaque de troisième étage (200-10) entraîne la plaque de base de réglage d'angle (200-11) à se déplacer, afin de permettre à la plaque de base de réglage d'angle (200-11) de se trouver à la position horizontale prédéterminée selon la première direction.

3. Le véhicule de levage suspendu selon la revendication 2, dans lequel le mécanisme de réglage synchrone comprend un premier ensemble roue et courroie synchrones (200-12), un deuxième ensemble roue et courroie synchrones (200-13) et un premier mécanisme d'entraînement ;
dans lequel le premier mécanisme d'entraînement est agencé sur un côté du mécanisme de glissement pour entraîner le coupleur de bloc coulissant (200-3) ;
dans lequel le premier ensemble roue et courroie synchrones (200-12) et le deuxième ensemble roue et courroie synchrones (200-13) sont agencés respectivement sur deux côtés du mécanisme de glissement ;
dans lequel une roue synchrone du premier ensemble roue et courroie synchrones (200-12) est reliée de manière fixe à la plaque de troisième étage (200-10), une courroie supérieure du premier ensemble roue et courroie synchrones (200-12) est pourvue d'un premier siège de courroie, un côté du premier siège de courroie est relié de manière fixe à la plaque de deuxième étage (200-9), et l'autre côté du premier siège de courroie est relié de manière fixe au coupleur de bloc coulissant (200-3), une courroie inférieure du premier ensemble roue et courroie synchrones (200-12) est pourvue d'un deuxième siège de courroie relié de manière fixe à la plaque de base de réglage d'angle (200-11) ; et
dans lequel une roue synchrone du deuxième ensemble roue et courroie synchrones (200-13) est reliée de manière fixe à la plaque de deuxième étage (200-9), et une courroie supérieure du deuxième ensemble roue et courroie synchrones (200-13) est pourvue d'un troisième siège de courroie relié de manière fixe à la face inférieure du mécanisme de préhension et de fixation, et une courroie inférieure du deuxième ensemble roue et courroie synchrones (200-13) est pourvue d'un quatrième siège de courroie relié de manière fixe à la plaque de troisième étage (200-10).

4. Le véhicule de levage suspendu selon la revendication 3, dans lequel le premier mécanisme d'entraînement comprend une première vis-mère (200-14) et un premier moteur, le coupleur de bloc coulissant (200-3) est emmanché sur la première vis-mère (200-14), et un arbre de sortie du premier moteur est relié à une extrémité de la première vis-mère (200-14) pour entraîner la première vis-mère (200-14).

5. Le véhicule de levage suspendu selon la revendication 1, dans lequel le mécanisme de commande de direction comprend en outre une première partie de détection configurée pour détecter une position du mécanisme à bascule et délivrer un premier signal de détection, et le premier signal de détection sert à indiquer si le mécanisme à bascule se déplace ou non vers la deuxième position préréglée du mécanisme à bascule ; et
dans lequel la première partie de détection comprend un premier capteur (24) et une première plaque de détection, le premier capteur (24) est installé sur l'électro-aimant rotatif (16), et la première plaque de détection est installée sur le mécanisme à bascule pour déclencher le premier capteur afin de délivrer le premier signal de détection en réponse au déplacement de la première plaque de détection avec le mécanisme à bascule.

6. Le véhicule de levage suspendu selon l'une quelconque des revendications 1 à 5, dans lequel le mécanisme de déplacement (200) comprend en outre un arbre rotatif (8), et la première plaque de base (11) est reliée à la plaque de base mobile (6) par l'arbre rotatif (8) ;
dans lequel le mécanisme de déplacement (200) comprend en outre un dispositif de réception d'énergie sans fil configuré pour fournir de l'énergie au servomoteur (10) après avoir reçu sans fil de l'énergie d'un câble haute fréquence (5) ; et
dans lequel le dispositif de réception d'énergie sans fil est installé sur une surface supérieure de la plaque de base mobile (6) afin de se trouver à une distance prédéterminée de l'arbre rotatif (8).

7. Le véhicule de levage suspendu selon l'une quelconque des revendications 1 à 6, comprenant en outre un corps de véhicule (700), dans lequel une partie supérieure du corps de véhicule (700) est reliée de manière fixe à une surface inférieure de la plaque de base mobile (6), et le dispositif de chargement transversal (300), le mécanisme de levage (400) et le mécanisme de serrage (500) sont tous agencés à l'intérieur du corps de véhicule (700) ; et
dans lequel le véhicule de levage suspendu comprend en outre une bande pare-chocs (700-1) installée à une deuxième position supérieure du corps de véhicule (700) et configurée pour assurer une protection anticollision entre deux mécanismes de déplacement (200) adjacents, et la deuxième position supérieure est définie au niveau des deux côtés supérieurs du corps de véhicule (700) parallèles à la direction d'extension de la voie de déplacement.

8. Le véhicule de levage suspendu selon la revendication 7, comprenant en outre un mécanisme anti-chute (600) installé à l'intérieur du corps de véhicule (700) ;
dans lequel le mécanisme anti-chute (600) comprend un premier support de liaison, en réponse au fait que l'objet cible n'est pas saisi par le mécanisme de serrage (500), le premier support de liaison se rétracte à l'intérieur du corps de véhicule (700), en réponse au fait que l'objet cible est saisi par le mécanisme de serrage (500), le premier support de liaison s'étend depuis l'intérieur du corps de véhicule (700) jusqu'en dessous de l'objet cible pour empêcher l'objet cible de tomber.

9. Le véhicule de levage suspendu selon la revendication 8, dans lequel le mécanisme anti-chute (600) comprend en outre un deuxième support de liaison lié de manière synchrone au premier support de liaison, en réponse au fait que l'objet cible n'est pas saisi par le mécanisme de serrage (500), le deuxième support de liaison se rétracte à l'intérieur du corps de véhicule (700), en réponse au fait que l'objet cible est saisi par le mécanisme de serrage (500), le deuxième support de liaison s'étend depuis l'intérieur du corps de véhicule (700) pour venir en butée contre l'objet cible afin d'empêcher l'objet cible de trembler.

10. Le véhicule de levage suspendu selon la revendication 1, dans lequel le mécanisme de levage (400) est relié à une surface inférieure du dispositif de chargement transversal (300) par un arbre rotatif (8).
